# EUROPÄISCHE PATENTSCHRIFT

(11) **EP 1 684 563 B1**
(45) Veröffentlichungstag und Bekanntmachung des Hinweises auf die Patenterteilung: **24.06.2009**
(21) Anmeldenummer: 06006209.8
(22) Anmeldetag: 19.03.2004
(51) Int. Cl.: H05K 7/20, G06F 1/20, F04D 29/60

(54) **Halteelement für einen Lüfter nach Art eines Klein-oder Kleinstlüfters**
Retaining element for small type fans
Élément de rétention pour de petits ventilateurs

(30) Priorität: 25.03.2003 DE 20304718 U
(43) Veröffentlichungstag der Anmeldung: 26.07.2006
(62) Teilanmeldung aus: 04006638.3
(73) Patentinhaber: ebm-papst St. Georgen GmbH & Co. KG, 78112 St. Georgen (DE)
(72) Erfinder: Winkler, Wolfgang, Arno, 78112 St. Georgen (DE)
(74) Vertreter: Raible, Tobias

(56) Entgegenhaltungen:
- EP-A- 0 755 177
- EP-A- 0 822 337
- US-A- 5 478 221
- US-B1- 6 183 214

## Beschreibung

Die Erfindung betrifft ein Halteelement für die Halterung eines Lüfters nach Art eines Klein- oder Kleinstlüfters auf einer Leiterplatte.

In der Elektronik wir immer häufiger eine direkte Kühlung einzelner wärmeerzeugender Elemente direkt an oder auf einer Leiterplatte gewünscht. Moderne Klein- und Kleinstlüfter können diese Anforderungen erfüllen, da sie schon mit Außenabmessungen von nur 25 x 25 x 8 mm, 40 x 40 x 10 mm, 40 x 40 x 20 mm oder auch 60 x 60 x 15 mm hergestellt werden, um nur beispielhaft einige typische Abmessungen zu nennen. Solche kleinen Lüfter haben ein Gewicht etwa im Bereich von 5 bis 100 g. Problematisch für ihre Anwendung direkt auf einer Leiterplatte sind einmal die Montage selbst, und zum anderen die hierzu notwendigen Halterungen und Befestigungen.

Eine Befestigung und Halterung, wie sie aus der EP 0 822 337 A2 bekannt ist, ist aufwändig und kompliziert in Aufbau und Montage, was ihre Anwendung in der Massenfertigung erschwert und in vielen Fällen zu teuer macht.

Aus der US-B1-6 183 214 kennt man eine Haltevorrichtung für Kleinstlüfter. Diese hat zwei seitliche Führungen und zwei untere Haltehaken, von denen jeder mit einer Einprägung versehen ist, welche bei der Montage in eine Öffnung des Lüfters einrastet.

Aus der EP-A1-0 755 177 kennt man eine Abschirmkappe, die an einer Leiterplatte eingerastet wird. Die Abschirmkappe hat einen federnden Arm, der im montierten Zustand gegen eine geeignete Leiterbahn der Leiterplatte anliegt und dadurch die Abschirmkappe mit Masse verbindet.

Aus der US-A-5 478 221 kennt man Lüfterkonstruktionen für die Montage auf einer Leiterplatte. Hierbei werden Teile einer solchen Konstruktion von der Vorderseite her durch entsprechende Löcher einer Leiterplatte gesteckt und auf deren Rückseite verlotet, um so den Lüfter an der Leiterplatte zu befestigen. Alternativ können Lüfterteile abgebogen werden und werden dann auf der Oberseite der Leiterplatte verlötet. Der elektrische Anschluss der Lüfter erfolgt über Anschlussleitungen, die an der Leiterplatte festgelötet werden.

Der Erfindung liegt die Aufgabe zugrunde, ein Halteelement zur Verfügung zu stellen, das einfach in seinem Aufbau und billig herzustellen ist und das eine sichere Befestigung eines solchen Lüfters auf einer Leiterplatte ermöglicht.

Nach der Erfindung wird diese Aufgabe gelöst durch den Gegenstand des Anspruchs 1. Ein solches Halteelement ist besonders klein und einfach und eignet sich deshalb für sehr kleine Lüfter, um diese sicher an einer Leiterplatte zu befestigen. Der formstabil verformbare Sperrfortsatz ermöglicht in Verbindung mit dem Einsteckfortsatz eine schnelle, automatisierbare Befestigung, z.B. in einer Bestückungsstraße der Massenfertigung.

Weitere Einzelheiten und vorteilhafte Weiterbildungen der Erfindung ergeben sich aus den im folgenden beschriebenen und in der Zeichnung dargestellten, in keiner Weise als Einschränkung der Erfindung zu verstehenden Ausführungsbeispielen, sowie aus den Unteransprüchen. Es zeigt:
- Fig. 1: ein Halteelement, das nicht einen Teil der Erfindung sondern ein Beispiel ist, das das Verständnis der Erfindung erleichtert.
- Fig. 2: das Halteelement der Fig. 1, befestigt an einem Bauelement,
- Fig. 3: das Halteelement der Fig. 1 und 2, arretiert an einer Leiterplatte,
- Fig. 4: eine Ausführungsform eines erfindungsgemäßen Halteelements in rechter und linker Ausführung,
- Fig. 5: die Halteelemente aus Fig. 4 am Bauelement, und
- Fig. 6: ein Halteelement aus Fig. 5 aus einem anderen Winkel betrachtet.

Die in den Figuren gleichen Bezugsziffern bezeichnen gleiche oder gleich wirkende Elemente.

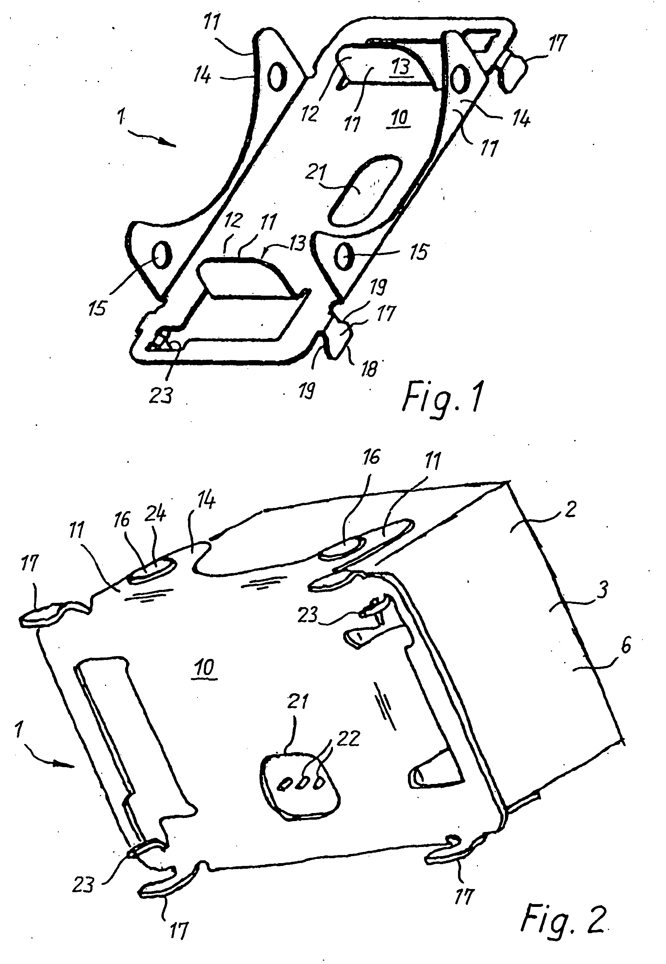

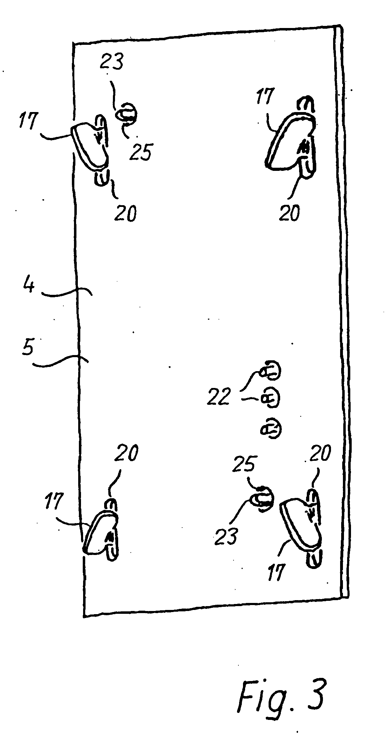

**Fig. 1** zeigt ein Halteelement 1 zur Befestigung eines Bauelements 2, **Fig. 2** zeigt das Halteelement 1 an einem Bauelement 2, und **Fig. 3** zeigt das Halteelement 1 an einer Leiterplatte 5 arretiert.

Das Halteelement 1 weist eine Halteelementgrundplatte 10, Halterungsausformungen 11 und Arretierungsfortsätze 17 auf.

Die Halterungsausformungen 11 dienen zur Halterung des Bauelements 2 und zur Fixierung des Bauelements 2 in seiner Lage zum Halteelement 1 (siehe hierzu auch Fig. 2). Die Halterungsausformungen 11, die dem Bauelement 2 Abstützflächen 13 bieten, sind durch Anschlaglaschen 12 und Befestigungslaschen 14 gebildet. Das Bauelement 2 kann mit den Halterungsausformungen 11 verklebt oder verschweißt werden, oder wie im gezeigten Beispiel (Fig. 2) mittels in den Befestigungslaschen 14 gestanzter Öffnungen 15, welche sich mit entsprechenden Öffnungen am Bauelement 2 überdecken, und mit einer durch die Öffnungen durchgreifenden Rohrniete 24 als Befestigungsmittel 16 verbunden werden. Die Befestigungslaschen 14 können zur mechanischen Verbindung auch Rastnasen oder ähnliches aufweisen, welche mit entsprechenden Kanten oder Vorsprüngen am Bauelement verrasten können.

Die vier Arretierungsfortsätze 17 dienen zur Befestigung des Halteelements 1 an einem Träger 4, im Beispiel an einer Leiterplatte 5 (vgl. Fig. 3).

Die Arretierungsfortsätze 17 wirken mit einer Aufnahme-Öffnung 20 so zusammen, dass eine dauerhafte Verbindung durch Formschluss entsteht, wenn die Arretierungsfortsätze in den im Wesentlichen schlitzförmigen Aufnahme-Öffnungen 20 der Leiterplatte 5 verformt werden.

Hierzu ist ein Arretierungsfortsatz 17 flach als Lasche ausgebildet und weist zu seinem vom Halteelement 1 wegragenden Ende 18 hin zwei breiter werdende Schrägflächen 19 auf (siehe Fig. 1). Durch diese Form wird auch ein Toleranzausgleich bezüglich der Dicke der Leiterplatte erreicht, da es immer zu einer spielfreien Verbindung zwischen Halteelement und Leiterplatte kommt.

Damit eine elektrische Kontaktierung zwischen an dem Bauelement 2 und an der Leiterplatte 5 ausgebildeten Stromzuführungen oder Leitungen erfolgen kann, weist das Halteelement 1 einen Kontaktierungs-Durchgriff 21 auf, durch welchen Kontaktierungsfortsätze 22 in Form von Drahtstiften, von dem Bauelement 2 zur Leiterplatte 5 durchreichen (siehe Fig. 2 und Fig. 3).

Das Halteelement 1 weist weiterhin zwei Lagefixierungsfortsätze 23 auf, welche in in der Leiterplatte 5 ausgebildete Aufnahmeöffnungen 25 eingreifen. Dies bewirkt, dass das Halteelement 1 in zwei von drei Raumrichtungen in seiner Lage relativ zur Leiterplatte 5 gehalten wird. Hierdurch werden auch mechanische Kräfte vom Bauelement bzw. vom Halteelement 1 auf die Leiterplatte 5 übertragen. Eine automatische Bestückung ist ermöglicht und vereinfacht durch die Selbstjustierung zur Leiterplatte.

Durch die Ausgestaltung des Halteelements 1 ist es möglich, dieses einstückig aus Blech herzustellen, wobei die Halterungsausformung 11 und/oder der Arretierungsfortsatz 17 und/oder der Lagefixierungsfortsatz 23 insbesondere durch Ausstanzen und Abkröpfen aus einem Blech hergestellt wird.

Ein solches Halteelement 1 eignet sich insbesondere auch für schwere Bauelemente 2, da die Halteelementgrundplatte 10 für die Aufnahme des Bauelements 2 eine stabile Basis bildet.

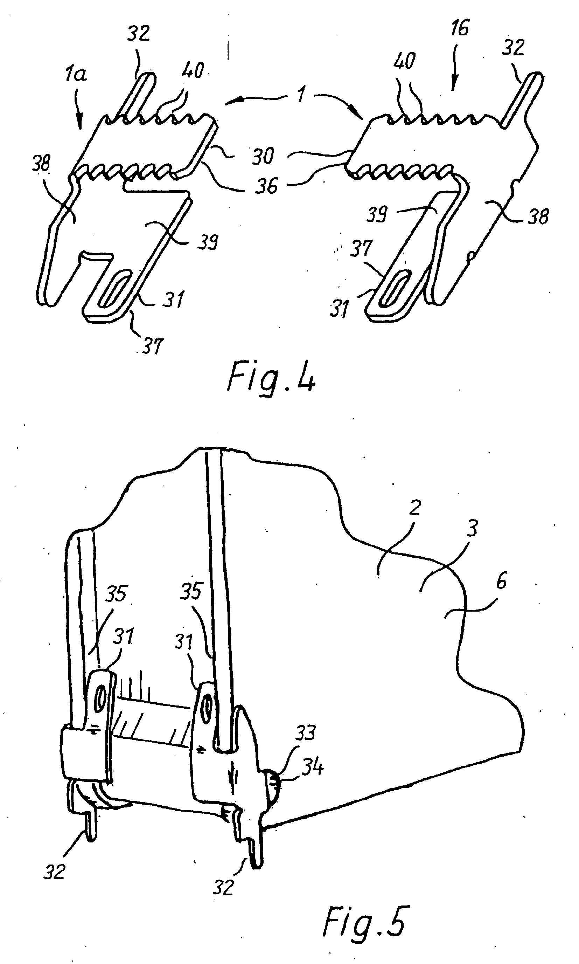

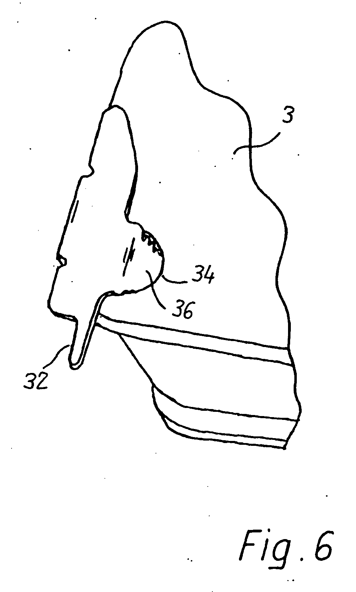

**Fig. 4** zeigt eine besonders vorteilhafte Ausgestaltung eines erfindungsgemäßen Halteelements 1, 1a, 1b zur Befestigung eines Bauelements, **Fig. 5** zeigt das Halteelement 1, 1a, 1b an einem Bauelement 2, und **Fig. 6** zeigt das Halteelement 1, 1a, 1b aus einem anderen Winkel betrachtet.

Gezeigt ist eine rechte 1a und eine linke 1b Ausführungsform, zur Anbringung an zwei gegenüberliegenden Seiten eines Bauelements 2 (siehe hierzu auch Fig. 5).

Das Halteelement 1, 1a, 1b weist einen Einsteckfortsatz 30 auf, welcher zur Einführung in eine Öffnung 33 vorgesehen ist, welche Öffnung 33 im Beispiel durch eine Durchführung 34 im Lüfter 3 ausgebildet ist. Der Einsteckfortsatz 30 ist als ein viele Widerhaken 40 aufweisender Einpresssteg 36 (auch Krallensteg genannt) ausgebildet. Dieser wird mit Kraftaufwand in die Öffnung 33 (Durchführung 34) am Lüfter 3 eingedrückt und bildet eine feste Verbindung zwischen Lüfter und Halteelement (siehe auch Fig. 6).

Das Halteelement 1 verfügt weiterhin über einen formstabil verformbaren Sperrfortsatz 31, der durch eine Lötlasche 37 gebildet ist, welcher eine elektrische Kontaktierung durch Löten oder durch einen Crimpanschluss ermöglicht.

Der Sperrfortsatz 31 (Lötlasche 37) ist so ausgestaltet, dass er zusammen mit dem Einsteckfortsatz 30 in der Öffnung 33 (Durchführung 34) des Bauelements 2 (Lüfter 3) eine formschlüssige Verbindung des Halteelements 1 mit dem Lüfter 3 bewirkt.

Hierzu wird der Sperrfortsatz 31 in seiner sperrenden Endposition am Lüfter 3 zu seiner Anlagefläche 39, von welcher er weg verläuft, leicht abgebogen (siehe Fig. 5). Der Einsteckfortsatz 30 kann nun nicht mehr aus der Öffnung 33 im Lüfter 3 gezogen werden, da der Sperrfortsatz 31 den Vorsprung 35 des Lüfters 3 hintergreift und das Herausziehen des Einsteckfortsatzes 30 aus der Öffnung 33 hemmt. Durch die doppelte Sicherung durch Sperrfortsatz 31 und Widerhaken 40 ist eine ungewollte Lösung des Halteelements 1a, 1b vom Lüfter 3 ausgeschlossen.

Zur Befestigung des Halteelements 1a, 1b an einem Träger, beispielsweise einer Leiterplatte, weist das Halteelement einen Befestigungsfortsatz 32 auf, welcher mit der Leiterplatte verlötet wird. Die Verbindung mit einer Leiterplatte oder dergleichen kann auch durch Verformung des Befestigungsfortsatzes 32 in einer Öffnung der Leiterplatte erfolgen.

Das Halteelement 1, 1a, 1b besteht bevorzugt ganz aus Metall und dient so über die Lötlasche 37 und den Befestigungsfortsatz 32 zur elektrischen Verbindung des Lüfters 3 mit Leitungen auf einer Leiterplatte. Hierdurch werden sonst notwendige zusätzliche Kontakte und Befestigungs- und Kontaktierungsschritte eingespart.

Das Halteelement 1 ist einstückig aus Blech ausgebildet, wobei der Einsteckfortsatz 30, der Sperrfortsatz 31 und der Befestigungsfortsatz 32 durch Ausstanzen und Abkröpfen aus einem Blech hergestellt sind, wodurch der Einsteckfortsatz 30 und die den Sperrfortsatz 31 tragende Anlagefläche (39) rechtwinklig von der Grundfläche 38 des Halteelements 1 weg verlaufen.

Naturgemäß sind im Rahmen der Erfindung vielfache Abwandlungen möglich.

## Patentansprüche

1. Halteelement zur Befestigung eines Lüfters (3) nach Art eines Klein- oder Kleinstlüfters auf einer Leiterplatte (5), welches Halteelement (1a, 1b) einen Einsteckfortsatz (30) aufweist, der zum Einpressen in eine Öffnung (33) des Lüfters (3) ausgebildet ist, wobei das Halteelement (1a, 1b) einen formstabil verformbaren Sperrfortsatz (31) aufweist, der so ausgestaltet ist, dass er zusammen mit dem Einsteckfortsatz (30) eine formschlüssige Verbindung mit dem Lüfter (3) bewirkt in der Weise, dass der Sperrfortsatz (31) eine Kante oder einen Vorsprung (35) des Lüfters (3) hintergreift, wobei der Sperrfortsatz zu seiner elektrischen Kontaktierung eine Lasche (37) aufweist, und das Halteelement (1a, 1b) wenigstens einen Befestigungsfortsatz (32) zur elektrischen und mechanischen Verbindung mit der Leiterplatte (5) aufweist.

2. Halteelement nach Anspruch 1, bei welchem der Einsteckfortsatz (30) mindestens einen Widerhaken (40) oder dergleichen aufweist.

3. Halteelement nach Anspruch 1 oder 2, bei welchem der Sperrfortsatz (31) durch eine Lötlasche (37) gebildet ist.

4. Halteelement nach einem der vorhergehenden Ansprüche, bei welchem der Einsteckfortsatz (30) als Krallensteg ausgebildet ist.

5. Halteelement nach einem der vorhergehenden Ansprüche, welches eine Grundfläche (38) aufweist, von welcher der Einsteckfortsatz (30) und eine den Sperrfortsatz (31) tragende Anlagefläche (39) im Wesentlichen rechtwinklig weg verlaufen.

6. Halteelement nach Anspruch 5, bei weichem der Sperrfortsatz (31) in einer sperrenden Lage am Lüfter (3) zu der Anlagefläche (39), von weicher er weg verläuft, leicht angewinkelt ist.

7. Halteelement nach einem der vorhergehenden Ansprüche, welches mindestens teilweise aus Blech ausgebildet ist, wobei der Einsteckfortsatz (30) und/oder der Sperrfortsatz (31) und/oder der Befestigungsfortsatz (32), insbesondere durch Ausstanzen und Abkröpfen, aus diesem Blech hergestellt sind.

8. Halteelement nach einem der Ansprüche 1 bis 7, welches mindestens teilweise aus Metall besteht, wobei die elektrische Verbindung zwischen Lüfter (3) und Leiterplatte (5) über das Halteelement (1a, 1b) an dessen Sperrfortsatz (31) und Befestigungsfortsatz (32) erfolgt.

9. Halteelement nach einem der vorhergehenden Ansprüche, welches mit einem Klein- oder Kleinstlüfter (3) verbunden ist.

## Claims

1. Holding element for fixing a fan (3), of the type of a small or very small fan, on a printed circuit board (5), which holding element (1a, 1b) has a plug-in extension (30), which is designed to be pressed into an opening (33) of the fan (3),
the holding element (1a, 1b) having a dimensionally stably ductile blocking extension (31), which is in such a form that together with the plug-in extension (30) it causes a positively locking joint with the fan (3), in such a way that the blocking extension (31) grips behind an edge or projection (35) of the fan (3), the blocking extension having a shackle (37) in its electrical contacting,
and the holding element (1a, 1b) having at least one fixing extension (32) for electrical and mechanical connection to the printed circuit board (5).

2. Holding element according to Claim 1, wherein the plug-in extension (30) has at least one barb (40) or similar.

3. Holding element according to Claim 1 or 2, wherein the blocking extension (31) is formed by a soldered shackle (37).

4. Holding element according to one of the preceding claims, wherein the plug-in extension (30) is in the form of a clawed fin.

5. Holding element according to one of the preceding claims, having a base area (38), from which the plug-in extension (30) and a contact surface (39) which carries the blocking extension (31) run essentially at right angles.

6. Holding element according to Claim 5, wherein the blocking extension (31) is slightly angled to the contact surface (39), away from which it runs, in a blocking position on the fan (3).

7. Holding element according to one of the preceding claims, which is made at least partly of sheet metal, and wherein the plug-in extension (30) and/or the blocking extension (31) and/or the fixing extension (32) are produced from this sheet metal, in particular by stamping out and bending at right angles.

8. Holding element according to one of Claims 1 to 7, which consists at least partly of metal, the electrical connection between the fan (3) and the printed circuit board (5) being made via the holding element (1a, 1b) on its blocking extension (31) and fixing extension (32).

9. Holding element according to one of the preceding claims, which is connected to a small or very small fan (3).

## Revendications

1. Élément de retenue pour la fixation d'un ventilateur (3) du genre d'un ventilateur miniature ou d'un micro-ventilateur sur une carte à circuit imprimé (5), cet élément de retenue (1a, 1b) présentant un prolongement d'emboîtement (30) qui est conçu pour être emmanché dans une ouverture (33) du ventilateur (3),
sachant que l'élément de retenue (1a, 1b) présente un prolongement de blocage (31) déformable sous une forme stable, qui est conçu de telle sorte qu'il produit conjointement avec le prolongement d'emboîtement (30) un assemblage en engagement positif avec le ventilateur (3), de telle sorte que le prolongement de blocage (31) s'engage derrière une arête ou une saillie (35) du ventilateur (3), sachant que le prolongement de blocage présente une patte (37) pour sa mise en contact électrique, et que l'élément de retenue (1a, 1b) présente au moins un prolongement de fixation (32) pour la liaison électrique et mécanique avec la carte à circuit imprimé (5).

2. Élément de retenue selon la revendication 1, selon lequel le prolongement d'emboîtement (30) présente au moins une barbe (40) ou analogue.

3. Élément de retenue selon la revendication 1 ou 2, selon lequel le prolongement de blocage (31) est formé par une patte de brasage (37).

4. Élément de retenue selon l'une des revendications précédentes, selon lequel le prolongement d'emboîtement (30) est réalisé sous forme de barrette à griffes.

5. Élément de retenue selon l'une des revendications précédentes, qui présente une surface de base (38) à partir de laquelle s'éloignent sensiblement à angle droit le prolongement d'emboîtement (30) et une surface d'appui (39) portant le prolongement de blocage (31).

6. Élément de retenue selon la revendication 5, selon lequel le prolongement de blocage (31), dans une position de blocage sur le ventilateur (3), est légèrement en angle par rapport à la surface d'appui (39), à partir de laquelle il s'éloigne.

7. Élément de retenue selon l'une des revendications précédentes, qui est réalisé au moins en partie en tôle, sachant que le prolongement d'emboîtement (30) et/ou le prolongement de blocage (31) et/ou le prolongement de fixation (32) sont réalisés à partir de cette tôle, notamment par découpage et coudage.

8. Élément de retenue selon l'une des revendications 1 à 7, qui est réalisé au moins en partie en métal, sachant que la liaison électrique entre le ventilateur (3) et la carte à circuit imprimé (5) s'effectue par l'intermédiaire de l'élément de retenue (1a, 1b) au niveau de son prolongement de blocage (31) et de son prolongement de fixation (32).

9. Élément de retenue selon l'une des revendications précédentes, qui est assemblé à un ventilateur miniature ou un micro-ventilateur (3).
